(19) Europäisches Patentamt
European Patent Office
Office européen des brevets

(11) **EP 3 753 912 A1**

(12) **EUROPEAN PATENT APPLICATION**
published in accordance with Art. 153(4) EPC

(43) Date of publication:
**23.12.2020 Bulletin 2020/52**

(51) Int Cl.:
**C04B 37/00** (2006.01)  **H01L 23/36** (2006.01)
**H01L 23/373** (2006.01)

(21) Application number: **18906674.9**

(22) Date of filing: **14.02.2018**

(86) International application number:
**PCT/JP2018/005089**

(87) International publication number:
**WO 2019/159257 (22.08.2019 Gazette 2019/34)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD TN**

(71) Applicant: **Mitsubishi Materials Corporation Tokyo 100-8117 (JP)**

(72) Inventors:
• **YUMOTO Ryouhei**
  **Saitama-shi, Saitama 330-8508 (JP)**
• **OOHIRAKI Tomoya**
  **Saitama-shi, Saitama 330-8508 (JP)**
• **OOI Soutarou**
  **Saitama-shi, Saitama 330-8508 (JP)**

(74) Representative: **Hoffmann Eitle Patent- und Rechtsanwälte PartmbB Arabellastraße 30 81925 München (DE)**

(54) **METHOD FOR MANUFACTURING CERAMIC/AL-SIC COMPOSITE MATERIAL JOINED BODY, AND METHOD FOR MANUFACTURING HEAT SINK-EQUIPPED SUBSTRATE FOR POWER MODULE**

(57) A method of producing a ceramics/Al-SiC composite material bonded body of the present invention includes the steps of: forming a magnesium layer having a thickness of 0.1 μm or more and 10 μm or less on a surface of at least one of the ceramics member and the Al-SiC composite material; obtaining a laminated body by laminating the ceramics member and the Al-SiC composite material via the magnesium layer; and bonding the ceramics member and the Al-SiC composite material by heating the laminated body in a temperature range of 550°C or more and 575°C or less, wherein the Al-SiC composite material includes an aluminum material made of an Al-Si alloy with a silicon content of 0.1 atomic% or more.

FIG. 1

**Description**

[Technical field]

The present invention relates: to a method of producing a ceramics/Al-SiC composite material bonded body, a ceramics member and an Al-SiC composite material being bonded together therein; and a method of producing a power module substrate with a heatsink, a ceramics substrate of a power module substrate and an Al-SiC composite material being bonded together therein.

[Background Art]

The power semiconductor element for controlling a large electric power used for controlling a wind power generator, an electric vehicle, a hybrid vehicle or the like has a large amount of heat generation. Thus, a power module substrate having: a ceramics substrate made of AlN (aluminum nitride), $Al_2O_3$ (alumina) or the like; and a circuit layer formed by bonding a metal plate with excellent conductivity on one surface of the ceramics substrate, are conventionally widely used as a substrate for mounting the power semiconductor element. In addition, a power module with a heatsink is provided. In the power module with a heatsink, a heatsink is bonded on other surface of the ceramics substrate in order to efficiently dissipate heat generated from the power semiconductor or the like mounted on the circuit layer.

As a material for the heatsink, an Al-SiC composite material (also referred to as an aluminum-based composite material) having a porous body made of SiC and an aluminum material made of aluminum or an aluminum alloy impregnated in the porous body is known.

For example, Patent Literature 1 discloses a power module substrate with a heatsink, in which the top plate of the heatsink is made of an Al-SiC composite material and the heatsink is bonded to a ceramics substrate. In Patent Literature 1, a method, in which a ceramics substrate and an Al-SiC composite material are bonded together by using aluminum with a purity of 99.98% or more (pure aluminum) as the aluminum member of the Al-SiC composite material with a Al-Si-based brazing material, is described as a method for bonding a ceramic substrate and an Al-SiC composite material. In addition, an alternative method for boding a ceramics substrate and an Al-SiC composite material is described in Patent Literature 1. In the alternative method, an aluminum alloy (Al-Si alloy) having a melting point less than 600°C is used as an aluminum member of the Al-SiC composite material; and a skin layer made of the Al-Si alloy is formed in the part on the side of the ceramics substrate of the Al-SiC composite material for a part of the skin layer to be melted.

[Prior Art Literature]

[Patent Literature]

Patent Literature 1: Japanese Unexamined Patent Publication No. 2010-98058

[Summary of Invention]

[Technical Problem]

In the case where the Al-SiC composite material in which the aluminum material is aluminum having a purity of 99.98% or more and a ceramic substrate are bonded with the Al-Si-based brazing material, it is necessary to set the bonding temperature higher than 600°C as described in Patent Literature 1.

On the other hand, in the case where the Al-SiC composite material in which the skin layer made of the Al-Si alloy having a melting point of 600°C or lower is formed and the ceramic substrate are bonded by melting a part of the skin layer of the Al-SiC composite material, it is possible to set the bonding temperature to 600°C or less. However, it is difficult to melt only a part of the skin layer of the Al-SiC composite material, and when the skin layer is melted, the aluminum alloy in the Al-SiC composite material also melts and a part of the aluminum alloy elutes out. In this case, there is a possibility that voids were generated in the SiC composite material. The formation of voids in the Al-SiC composite material causes a decrease in the thermal conductivity of the Al-SiC composite material.

The present invention has been made in view of the above-mentioned circumstances. The purpose of the present invention is to provide a method of producing a ceramic/Al-SiC composite material bonded body and a method of producing a power module substrate with a heatsink. In there methods, a ceramics member and an Al-SiC composite material are bonded together with high strength without eluting the aluminum material in the Al-SiC composite material by heating them at a relatively low temperature.

[Solution to Problem]

In order to solve the above-described problems and achieve the above-described object, a method of producing a ceramics/Al-SiC composite material bonded body, which is an aspect of the present invention, is a method of producing a ceramics/Al-SiC composite material bonded body, a ceramics member and an Al-SiC composite material that includes: a porous body made of SiC; and an aluminum material made of an Al-Si alloy impregnated in the porous body and having a silicon content of 0.1 atomic% or more, being bonded together in the method, the method including the steps of: forming a magnesium layer having a thickness of 0.1 $\mu$m or more and 10 $\mu$m or less on a surface of at least one of the ceramics member and the Al-SiC composite material; obtaining a laminated body by laminating the ceramics member and the Al-SiC composite material via the magnesium layer; and bonding the ceramics member and the Al-SiC composite material by heating the laminated body in a temperature range of 550°C or more and 575°C or less.

According to the method of producing a ceramics/Al-SiC composite material bonded body configured as described above, the aluminum material of the Al-SiC composite material is an Al-Si alloy having a silicon content of 0.1 atomic% or more; and the magnesium layer disposed between the ceramic member and the Al-SiC composite material is in contact with the Al-Si alloy. Thus, the ceramics member and the Al-SiC composite material can be bonded together by heating them at a relatively low temperature at 550°C or more and 575°C or less.

That is, the magnesium in the magnesium layer removes the oxide film on the surface of the ceramic member or the Al-SiC composite material and diffuses into the aluminum material of the Al-SiC composite material. Then, a solid-liquid coexistence region is formed between the ceramic member and the Al-SiC composite material from aluminum, magnesium, silicon and $Mg_2Si$ formed by a reaction of between the diffused magnesium and silicon. Then, the ceramic member and the Al-SiC composite material are bonded together via the bonding part containing aluminum, magnesium, and silicon by solidification of the solid-liquid coexistence region. Further, magnesium oxide is formed by the reaction between these oxide films and magnesium.

The ceramic member and the Al-SiC composite material can be bonded with high strength by the solidified part (bonding part) of the liquid phase.

Further, the ceramics member and the Al-SiC composite material can be bonded together without the aluminum material in the Al-SiC composite material being eluted out since the ceramics member and the SiC composite material are bonded by forming the solid-liquid coexistence region. Moreover, it is possible to suppress the generation of voids (voids) due to the outflow of the aluminum material of the Al-SiC composite material and the cracking of the Al-SiC composite material since the aluminum material in the Al-SiC composite material does not elute out.

Here, if the silicon content of the aluminum material of the Al-SiC composite material is less than 0.1 atomic%, the amount of liquid phase in the solid-liquid coexistence region decreases, and it is possible that the bonding rate between the ceramic substrate and the Al-SiC composite material is reduced.

In addition, if the thickness of the magnesium layer is less than 0.1 $\mu$m, the amount of $Mg_2Si$ produced during heating is reduced, and the bonding rate between the ceramic substrate and the Al-SiC composite material is deteriorated. On the other hand, when the thickness of the magnesium layer exceeds 10 $\mu$m, the liquid phase in the solid-liquid coexistence region increases and the bonding rate decreases.

Furthermore, if the heating temperature is less than 550°C, the amount of liquid phase in the solid-liquid coexistence region decreases, and the bonding rate decreases. If the temperature exceeds 575°C, melting of matrix of the heatsink occurs.

In the method of producing a ceramic/Al-SiC composite material bonded body according to the one aspect of the present invention, it is preferable that a ratio Si/Mg in an atomic ratio is in a range of 0.01 or more and 99.0 or less, the ratio Si/Mg being a ratio of a Si amount in the Al-Si alloy existing in a thickness range of 50 $\mu$m from a surface of a bonding surface between the Al-SiC composite material and the ceramics member to a Mg amount existing in the magnesium layer in the laminated body.

In this case, $Mg_2Si$ is likely to be formed in the solid-liquid coexistence region formed by heating, so that the ceramic member and the Al-SiC composite material can be reliably bonded.

A method of producing a power module substrate with a heatsink, which is an other aspect of the present invention, is a method of producing a power module with a heatsink, a ceramics substrate of a power module substrate and a heatsink constituted of a Al-SiC composite material being bonded together in the method, the power module substrate including: a ceramics substrate; and a circuit layer bonded on one surface of the ceramics substrate, and the Al-SiC composite material including: a porous body made of SiC; and an aluminum material made of an Al-Si alloy impregnated in the porous body and having a silicon content of 0.1 atomic% or more, the method including the steps of: forming a magnesium layer having a thickness of 0.1 $\mu$m or more and 10 $\mu$m or less on a surface of at least one of the ceramics substrate and the Al-SiC composite material; obtaining a laminated body by laminating the ceramics substrate and the Al-SiC composite material via the magnesium layer; and bonding the ceramics substrate and the Al-SiC composite material by heating the obtained laminated body in a temperature range of 550°C or more and 575°C or less.

According to the method of producing a power module substrate with a heatsink configured as described above, the ceramics member and the Al-SiC composite material can be bonded with high strength without the aluminum material in the Al-SiC composite material being eluted out by heating them at a relatively low temperature at 50°C or more and 575°C or less as in the above-described method of producing a ceramics/Al-SiC composite material bonded body.

In the method of producing a power module substrate with a heatsink according to the other aspect of the present invention, it is preferable that a ratio Si/Mg in an atomic ratio is in a range of 0.01 or more and 99.0 or less, the ratio Si/Mg being a ratio of a Si amount in the Al-Si alloy existing in a thickness range of 50 $\mu$m from a surface of a bonding surface between the Al-SiC composite material and the ceramics substrate to a Mg amount existing in the magnesium layer in the laminated body.

In this case, $Mg_2Si$ is likely to be formed in the solid-liquid coexistence region formed by heating, so that the ceramic substrate and the Al-SiC composite material can be reliably bonded as in the above-described method of producing a ceramic/Al-SiC composite material bonded body.

[Advantageous Effects of Invention]

According to the present invention, it is possible to provide a method of producing a ceramic/Al-SiC composite material bonded body and a method of producing a power module substrate with a heatsink. In there methods, a ceramics member and an Al-SiC composite material are bonded together with high strength without eluting the aluminum material in the Al-SiC composite material by heating them at a relatively low temperature.

[Brief Description of Drawings]

Figure 1 is a cross-sectional view of a power module substrate with a heatsink obtained by a method of producing a power module substrate with a heatsink according to an embodiment of the present invention.

Figure 2A is an enlarged cross-sectional view of a part in which a ceramics substrate of a power module substrate with a heatsink obtained by the method of producing a power module substrate with a heatsink according to an embodiment of the invention; and a metal layer are bonded together.

Figure 2B is an enlarged cross-sectional view of a part in which a ceramics substrate of a power module substrate with a heatsink obtained by the method of producing a power module substrate with a heatsink according to an embodiment of the invention; and a metal layer are bonded together.

Figure 3 is a flowchart showing a method of producing a power module substrate with a heatsink according to the embodiment of the present invention.

Figure 4 is an explanatory view showing a method of producing a power module substrate with a heatsink that is an embodiment of the present invention.

Figure 5A is a photograph illustrating the Al-SiC composite material in which melting of a matrix occurs in Example.

Figure 5B is a photograph illustrating the Al-SiC composite material in which melting of a matrix occurs in Example.

[Descriptions of Embodiments]

Hereinafter, a method of producing a ceramic/Al-SiC composite material bonded body and a method of producing a power module substrate with a heatsink according to the present invention will be described with reference to the drawings. Each embodiment described below is specifically described in order to better understand the technical concept of the invention, and does not limit the invention unless otherwise specified. Further, in the drawings used in the following description, in order to facilitate understanding of the features of the present invention, for convenience, there are cases where essential parts enlarged are shown. In that case, the dimensional ratio of each component is not always the same as the actual one.

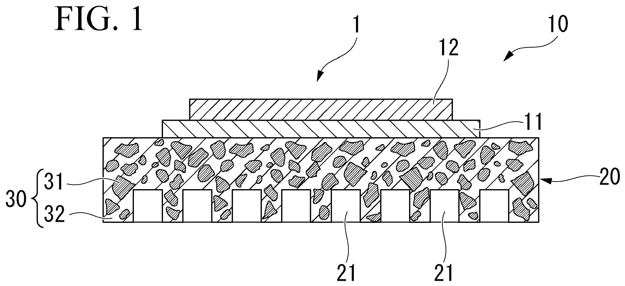

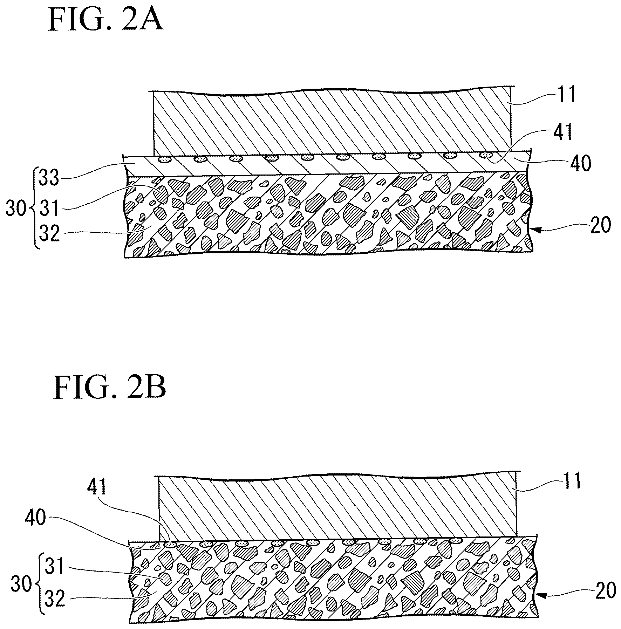

First, a configuration of a power module substrate with a heatsink obtained by the method of producing a power module substrate with a heatsink according to an embodiment of the present invention will be described with reference to Figs. 1, 2A and 2B.

As shown in Fig. 1, the power module substrate 1 with a heatsink includes a power module substrate 10 and a heatsink 20.

The power module substrate 10 includes a ceramic substrate 11 and a circuit layer 12 bonded to one surface (the upper surface in FIG. 1) of the ceramic substrate 11.

The ceramic substrate 11 is for preventing electrical connection between the circuit layer 12 and the heatsink 20, and is constituted of ceramics having excellent insulation and heat dissipation properties such as $Si_3N_4$ (silicon nitride), AlN (aluminum nitride) and $Al_2O_3$ (alumina). In this embodiment, it is made of AlN. The thickness of the ceramic substrate 11 is set in the range of 0.2 to 1.5 mm, and in the present embodiment, it is set to 0.635 mm.

The circuit layer 12 is formed by bonding an aluminum member made of aluminum or an aluminum alloy to one surface of the ceramic substrate 11. As the aluminum member, aluminum having a purity of 99 mass% or more (2N aluminum) or aluminum having a purity of 99.99 mass% or more (4N aluminum) can be used. In this embodiment, a rolled plate of 4N aluminum is used. The thickness of the circuit layer 12 is set in the range of 0.1 mm or more and 1.0 mm or less, and is set to 0.4 mm in this embodiment. The circuit layer 12 and the ceramic substrate 11 are bonded by, for example, an Al-Si brazing material.

The heatsink 20 is for dissipating heat on the power module substrate 10 side. The heatsink 20 is provided with a channel 21 through which a cooling fluid flows.

The heatsink 20 is composed of an Al-SiC composite material (so-called AlSiC) 30. The Al-SiC composite material 30 has a porous body 31 made of SiC and an aluminum material 32 made of aluminum or an aluminum alloy impregnated in the porous body 31. As the aluminum material 32, pure aluminum such as aluminum having a purity of 99 mass% or more (2N aluminum) or aluminum having a purity of 99.99 mass% or more (4N aluminum), an aluminum alloy having a composition including: 80 mass% or more and 99.99 mass% or less of Al; 0.01 mass% or more and 13.5 mass% or less of Si; 0.03 mass% or more and 5.0 mass% or less of Mg; and the balance including impurity, can be used. Alternatively, an aluminum alloy such as ADC12 or A356 can be used.

The Al-SiC composite material 30 may have a skin layer 33 . The skin layer 33 is a layer formed by leaching a part of the aluminum material 32 on the surface when the aluminum material 32 is melted and impregnated in SiC to be the porous body 31 to produce the Al-SiC composite material. Therefore, the skin layer 33 has the same composition as that of the aluminum material 32. The thickness of the skin layer 33 is adjusted by cutting the exuded aluminum material.

The thickness of the heatsink 20 can be 0.5 mm to 5.0 mm. The thickness of the heatsink 20 includes the thickness of the skin layer when the skin layer is formed. Further, the thickness of the skin layer per one side is preferably 0.01 to 0.1 times the thickness of the heatsink 20.

In the power module substrate 1 with a heat sink of this embodiment, the area of the heat sink 20 is set to be the same as or larger than the area of the ceramic substrate 11.

Here, the structure of the bonding part between the ceramic substrate 11 and the heatsink 20 will be described with reference to Figs. 2A and 2B.

As shown in Figs. 2A and 2B, the ceramic substrate 11 and the Al-SiC composite material 30 that is the heatsink 20 are bonded via the bonding part 40. Fig. 2A shows the case where Al-SiC composite material 30 has the skin layer 33, and the bonding part 40 is formed in the skin layer 33. FIG. 2B shows the case where the Al-SiC composite material 30 does not have the skin layer 33, and the bonding part 40 is formed in the aluminum material 32 of the Al-SiC composite material 30.

The bonding part 40 includes aluminum, magnesium, and silicon. The bonding part 40 is made of aluminum produced by heating the laminated body in which the ceramics substrate 11 and the Al-SiC composite material 30 are laminated via the magnesium layer in the method of producing a power module substrate with a heatsink described later. It is a layer formed by solidifying a solid-liquid coexisting region containing magnesium and silicon.

Magnesium oxide 41 is deposited on the bonding part 40. The magnesium oxide 41 is deposited near the bonding interface between the ceramic substrate 11 and the bonding part 40. Magnesium oxide 41 is typically magnesium oxide (MgO), spinel ($MgAl_2O_4$) and composites thereof. The magnesium oxide 41 is a product produced by a reaction between: an oxide film present on the surface of the ceramic substrate 11 and the surface of the Al-SiC composite material 30; and magnesium in the magnesium layer, in the method of producing a power module substrate with a heatsink described later. In addition, $Mg_2Si$ may be further deposited on the bonding part 40.

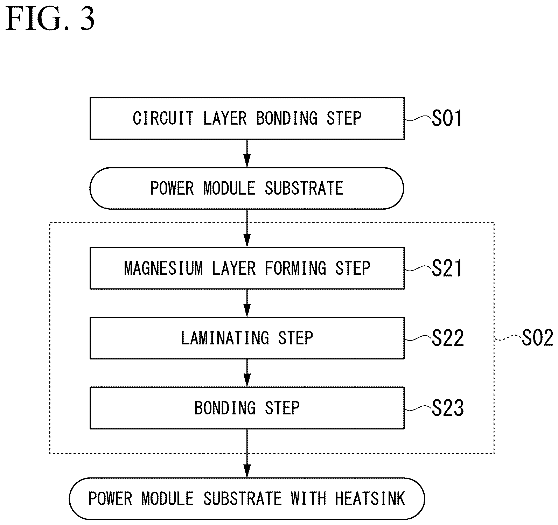

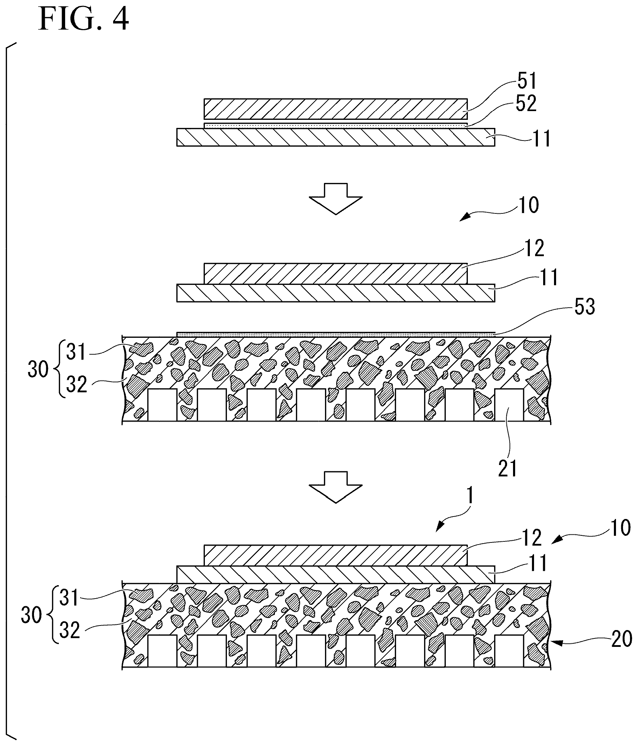

Next, a method of producing the power module substrate 1 with a heatsink according to the present embodiment will be described with reference to Figs. 3 and 4. As shown in Fig. 3, the method of producing the power module substrate 1 with a heatsink according to the present embodiment has the circuit layer bonding step S01 and the heatsink bonding step S02.

First, as shown in FIG. 4, the aluminum member 51 to be the circuit layer 12 is laminated on one surface of the ceramic substrate 11 with a brazing material 52 interposed therebetween. Next, the circuit layer 12 is bonded to the ceramic substrate 11 by heating while applying pressure in the stacking direction.

Through the circuit layer bonding step S01 described above, the power module substrate 10 in this embodiment is produced.

(Heatsink bonding step S02)

Next, the ceramics substrate 11 of the power module substrate 10 and the Al-SiC composite material 30 that becomes the heatsink 20 are bonded to each other to produce the power module substrate 1 with a heatsink. As shown in FIG. 3, the heatsink bonding step S02 includes the magnesium layer forming step S21, the laminating step S22, and the bonding step S23.

In the magnesium layer forming step S21, as shown in FIG. 4, the magnesium layer 53 is formed on the surface of at least one of the ceramic substrate 11 and the Al-SiC composite material 30. In this embodiment, the magnesium layer 53 is formed on the surface of the Al-SiC composite material 30.

The magnesium layer 53 preferably has a magnesium concentration of 80 atomic% or more, and particularly preferably 90 atomic% or more. When the magnesium concentration of the magnesium layer 53 is 80 atomic% or more, a solid-liquid coexisting region is likely to be formed and $Mg_2Si$ is easily formed in the solid-liquid coexisting region in the bonding step S23 described later .

The thickness of the magnesium layer 53 is in the range of 0.1 $\mu$m or more and 10 $\mu$m or less (the total thickness when formed on both the ceramic substrate 11 and the Al-SiC composite material 30). If the thickness of the magnesium layer 53 is too thin, the amount of $Mg_2Si$ produced in the bonding step S23, which will be described later, decreases, and the bonding strength between the ceramic substrate 11 and the Al-SiC composite material 30 decreases. On the other hand, if the magnesium layer 53 becomes too thick, excessive liquid phase is formed in the solid-liquid coexistence region in the bonding step S23, which will be described later, and it is possible that the bonding rate between the ceramic substrate 11 and the Al-SiC composite material 30 decreases.

As a method of forming the magnesium layer 53, a sputtering method, a vapor deposition method, or a method of applying a magnesium powder paste and drying it can be used.

Next, in the laminating step S22, the ceramic substrate 11 and the Al-SiC composite material 30 are laminated with the magnesium layer 53 interposed therebetween to obtain the laminated body.

In the obtained laminate, the ratio of the amount of silicon to the amount of magnesium (Si/Mg) is in the range of 0.01 or more and 99.0 or less in atomic ratio, the ratio Si/Mg being a ratio of a Si amount in the Al-Si alloy existing in a thickness range of 50 $\mu$m from the surface of the bonding surface between the Al-SiC composite material 30 and the ceramics substrate 11 to a Mg amount existing in the magnesium layer 53. When the abundance ratio of Si and Mg is within the above-described range, $Mg_2Si$ necessary for bonding the ceramic substrate 11 and the Al-SiC composite material 30 is easily formed in the bonding step S23 described later. Therefore, the ceramic substrate 11 and the Al-SiC composite material 30 can be reliably bonded. Si/Mg is preferably in the range of 1.1 or more and 6.7 or less.

Here, the amount of magnesium present in the magnesium layer 53 can be obtained from the purity, thickness and density of the magnesium layer 53. The amount of silicon present in the range from the surface of the Al-SiC composite material 30 to the thickness of 50 $\mu$m can be obtained from the silicon content of the Al-SiC composite material 30. When the Al-SiC composite material 30 has a skin layer, the silicon content of the Al-SiC composite material 30 includes the amount of silicon in the skin layer 33.

Next, in the bonding step S23, the obtained bonded body is heated in the temperature range of 550°C or more and 575°C or less, while being pressed in the stacking direction. By this heating, the magnesium of the magnesium layer 53 removes the oxide film existing on the surfaces of the ceramic substrate 11 and the Al-SiC composite material 30 and is diffused into the aluminum material 32 of the Al-SiC composite material 30. A solid-liquid coexistence region is formed between aluminum and the Al-SiC composite material 30 from aluminum, magnesium, silicon, and $Mg_2Si$ formed by the reaction of the diffused magnesium and silicon. Then, as the solid-liquid coexistence region is solidified, as shown in Figs. 2A and 2B, the ceramic substrate 11 and the Al-SiC composite material 30 are bonded together via the bonding part 40 containing aluminum, magnesium, and silicon.

When the Al-SiC composite material 30 has the skin layer 33, the bonding part 40 is formed in the skin layer 33 on the ceramic substrate 11 side. When the skin layer 33 is not provided, the bonding part 40 is formed in the aluminum material 32 on the ceramic substrate 11 side.

Also, the magnesium oxide 41 is formed by the reaction of these oxide films with magnesium. Further, when the bonding temperature is high or when the holding time is long, almost no $Mg_2Si$ may be observed in the bonding part 40. The solidification of the solid-liquid coexistence region may be solidification by cooling, or so called "isothermal coagulation" in which the melting point of the liquid phase in the solid-liquid coexistence region is increased by diffusion of magnesium or the like, and solidification occurs while maintaining the heating temperature.

In the present embodiment, as bonding conditions of the above-described bonded body, a load in the stacking direction is within a range of 0.1 MPa or more and 3.5 MPa or less (1 kgf/cm$^2$ or more and 35 kgf/cm$^2$ or less), and bonding temperature is 550°C or more and 575°C or less. The holding time is within the range of 15 minutes to 180 minutes. If the bonding temperature becomes too low, the solid-liquid coexistence region may not be formed. On the other hand, if the bonding temperature becomes too high, it is possible that the matrix of the Al-SiC composite material 30 is melted. The bonding temperature is preferably lower than the melting point of the aluminum material 32 in order to prevent the aluminum material 32 of the Al-SiC composite material 30 from flowing out.

Further, if the applied load is too low, the solid-liquid coexisting region is less likely to come into contact with the Al-SiC composite material 30, and there is a risk of poor bonding. If the applied load becomes too high, the circuit layer 12, the ceramic substrate 11, or the Al-SiC composite material 30 may be cracked or damaged.

According to the method of producing the power module substrate 1 with a heatsink having the above-described configuration according to the present embodiment, in the heatsink bonding step S02, the ceramic substrate 11 of the power module substrate 10 and the Al-SiC to be the heatsink 20 are formed. Since the magnesium of the magnesium layer 53 is diffused into the Al-Si alloy of the Al-SiC composite material 30 to form the solid-liquid coexisting region, the composite material 30 and the composite material 30 are bonded to each other. The ceramic substrate 11 and the Al-SiC composite material 30 can be bonded with high strength without eluting the aluminum material 32. In addition, since the aluminum material in the Al-SiC composite material does not elute, it is possible to suppress the generation of voids (voids) due to the outflow of the aluminum material of the Al-SiC composite material and the cracking of the Al-SiC composite material.

Furthermore, in the present embodiment, the ratio of the amount of silicon to the amount of magnesium (Si/Mg) is in the range of 0.01 or more and 99.0 or less in atomic ratio, the ratio Si/Mg being a ratio of a Si amount in the Al-Si alloy existing in a thickness range of 50 $\mu$m from a surface of a bonding surface between the Al-SiC composite material 30 and the ceramics substrate 11 to a Mg amount existing in the magnesium layer 53. Therefore, $Mg_2Si$ necessary for bonding the ceramic substrate 11 and the Al-SiC composite material 30 is easily formed, and the ceramic substrate 11 and the Al-SiC composite material 30 can be reliably bonded.

Therefore, the power module substrate 1 with a heatsink obtained by the method of producing a power module substrate with a heatsink according to the present embodiment has a high bonding strength between the ceramic substrate 11 and the heatsink 20 (Al-SiC composite material 30). In addition, since it has less void space (voids) in the heatsink, excellent heat cycle reliability is obtained.

Although the embodiment of the present invention has been described above, the present invention is not limited to this, and can be appropriately modified without departing from the technical concept of the invention.

For example, although the present embodiment has been described by taking the power module substrate with a heat sink as an example, the present invention is not limited to this, and as long as it is a ceramic/Al-SiC composite material obtained by bonding a ceramic member and an Al-SiC composite material, it would be understood within the scope of the present invention.

Further, in the present embodiment, the circuit layer 12 is formed by bonding rolled plates of 4N aluminum, but the present invention is not limited to this, and by bonding a copper or copper alloy plate to the ceramic substrate 11, a circuit layer (thickness: 0.3 mm to 3.0 mm) made of copper or copper alloy may be formed. In this case, when a copper or copper alloy plate is bonded to the ceramic substrate 11, an active metal brazing method using Ag-Cu-Ti or Ag-Ti brazing material is preferably used.

Further, the circuit layer may be composed of a laminated body of aluminum and copper (or an alloy thereof). In this case, the aluminum layer is formed on the ceramic substrate, and the copper layer is formed on the aluminum layer.

[Example]

A confirmation experiment conducted to confirm the effectiveness of the present invention will be described.

[Examples 1 to 16 of the present invention and Comparative Examples 1 to 5]

As shown in Table 1, a metal plate for forming a circuit layer, a ceramic substrate (40 mm×40 mm, AlN and $Al_2O_3$: thickness 0.635 mm, SiN: 0.32 mm), and AlSiC A composite material (AlSiC) plate material (50 mm × 60 mm × thickness 5 mm (in case of having skin layers: skin layers are formed on both sides, thickness of one side is 0.2 mm)) and a brazing material were prepared.

The melting point of the aluminum material of the Al-SiC composite material is 570°C for ADC12, 660°C for 4N aluminum, 655°C for 3N aluminum, and 650°C for 2N aluminum.

The metal plate for forming a circuit layer and the ceramics substrate were bonded together as described below to obtain a ceramics substrate on which a circuit layer was formed.

When the circuit layer forming metal plate was 4N-Al, the circuit layer forming metal plate (37 mm × 37 mm × thickness 0.4 mm) was provided on one surface of the ceramic substrate with a brazing material (Al-7.5 mass% Si, thickness: 12 $\mu$m). Then, the metal plate for forming a circuit layer was bonded to the ceramic substrate by heating while applying pressure in the stacking direction to obtain a ceramic substrate on which the circuit layer was formed. The load in the stacking direction was 0.6 MPa, the bonding temperature was 645°C, and the holding time was 45 minutes.

When the circuit layer forming metal plate was Cu, a copper plate (37 mm × 37 mm × thickness 0.6 mm) made of oxygen-free copper was provided on one surface of the ceramic substrate through a brazing material (Ag-9.8 mass% Ti), and laminated under a load of 0.6 MPa, a bonding temperature of 830°C, and a holding time of 30 minutes to obtain a ceramic substrate having a circuit layer formed thereon.

Next, as shown in Table 1, magnesium layers having thicknesses shown in Table 1 were formed on one of the surfaces of the ceramic substrates and the Al-SiC composite materials to which the circuit layers were bonded. The magnesium layers were formed by a vapor deposition method (ion plating method).

The purity of the formed magnesium layers; and the ratios of the amounts of silicon to the amounts of magnesium (Si/Mg) are shown in Table 1 below., the ratio Si/Mg being a ratio of a Si amount in the Al-Si alloy existing in a thickness range of 50 $\mu$m from the surface of a bonding surface between the Al-SiC composite material and the ceramics member to the Mg amount existing in the magnesium layer. Si/Mg was measured by the following method.

(Method of measuring Si/Mg)

The amount of magnesium in the magnesium layer was determined by measuring the purity and thickness of the magnesium layer and setting the density of the magnesium layer as 1.74 g/cm$^3$. The purity of the magnesium layer was measured using EPMA, and the thickness was measured by cross-section SEM observation.

In the case of an Al-SiC composite material with a skin layer, the amount of silicon in the Al-Si alloy was determined by measuring the silicon concentration of the skin layer. In the case of the Al-SiC composite material without the skin layer, it was determined by measuring the silicon concentration in the Al-SiC composite material. The silicon concentration was measured using EPMA.

Then, the ratio of Si and Mg (Si/Mg) was calculated from the calculated amounts of magnesium and silicon.

Next, the ceramic substrate and the Al-SiC composite material were laminated with the magnesium layer interposed therebetween to obtain laminated bodies. Then, the Al-SiC composite materials (heatsink) were bonded to the ceramic substrates by heating while applying pressure in the stacking direction, and an evaluation sample (substrates for power modules with a heatsink) were produced. The bonding conditions are as shown in Table 1.

[Conventional Examples 1 to 4]

After the circuit layers were bonded in the same manner as in Example 1 of the present invention, the Al-SiC composite materials were applied to the other surfaces of the ceramic substrates on which the circuit layers were formed, via the Al-Si brazing foil described in Table 1. By laminating and then heating while applying pressure in the laminating direction, samples for evaluation (power module substrates with a heatsink) were produced.

(Initial bonding rate)

Using the obtained evaluation samples, the bonding rates between the ceramic substrates and the heat sinks were measured to evaluate the initial bonding property. Specifically, they were evaluated using the ultrasonic flaw detector (INSIGHT-300 manufactured by Insight Co., Ltd.) and calculated from the following formula. Here, the initial bonding area is the area to be bonded before bonding, that is, the area (40 mm × 40 mm) of the ceramic substrates. In the images obtained by binarizing the ultrasonic flaw detection image, the peeling is shown by the white portion in the bonding part, and thus the area of this white portion was defined as the peeling area. The evaluation results are shown in Table 1.

$$(Bonding\ rate) = \{(initial\ bonded\ area) - (non\text{-}bonded\ area)\}/(initial\ bonded\ area) \times 100$$

(Bonding rate after cooling/heating cycle)

The bonding rate after the thermal cycle was evaluated using the thermal shock tester TSB-51 manufactured by Espec. Two thousands cycles of 10 minutes at -40°C and 10 minutes at 175°C were performed in the liquid phase (fluorinert) on the above-mentioned evaluation samples. The bonding rates were measured by the same method as described above. The evaluation results are shown in Table 1.

(Evaluation of matrix melting)

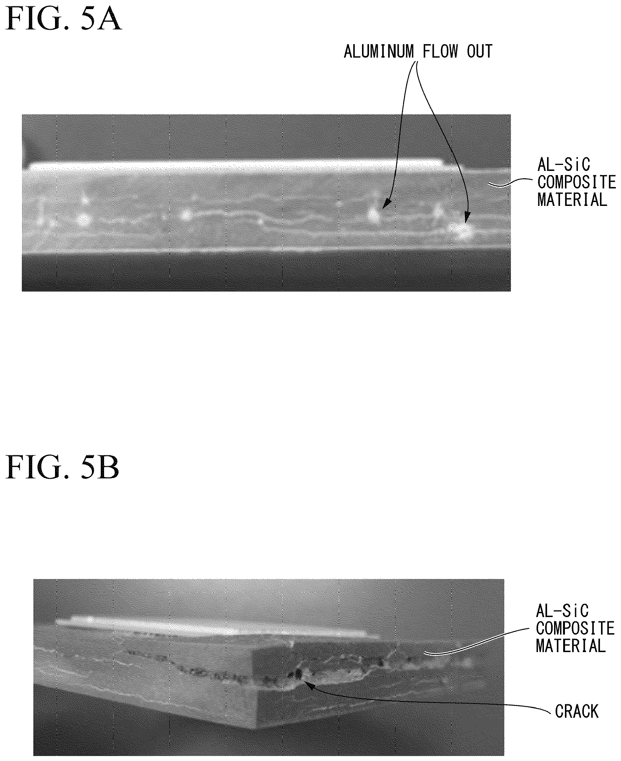

The surfaces of the obtained Al-SiC composite materials of the evaluation samples were visually observed, and the samples in which the outflow or cracking of aluminum due to the melting of the matrix were confirmed were evaluated as "B", and the samples which were not confirmed were evaluated as "A." Figs. 5A and 5B are photographs of side surfaces of examples of the Al-SiC composite materials in which the matrixes have been melted. FIG. 5A is a side view photograph of an Al-SiC composite material in which aluminum flows out due to melting of the matrix. FIG. 5B is a side view photograph of the corner portion of the Al-SiC composite material in which a crack was generated due to melting of the matrix. As shown in FIG. 5A, when the outflow of aluminum occurred due to the melting of the matrix, the aluminum existed in the form of beads on the surface of the Al-SiC composite material.

[Table 1]

| | Configurations of Power Module Substrate with a Heatsink | | | | | | | | | | | Evaluation | | |
| | Metal Plate (Circuit layer) | Ceramics Substrate | Al-SiC Complex Material (Heatsink) | | | Method of Bonding Ceramics Substrate and Heatsink | | | | | | | Initial Bonding Rate (%) | Bonding Rate after Cooling/ Heating Cycles (%) | Matrix Melting |
| | | | Al material | Si concentration (atomic%) | Skin layer | Mg layer | | | | Load (MPa) | Bonding temperature (°C) | | | | |
| | | | | | | Provided location | Thickness ($\mu$m) | Purity (atomic%) | Si/Mg | | | | | | |
| Ex. 1 | 4N-Al | AlN | ADC12 | 10 | present | heatsink side | 2 | 99.9 | 3.36 | 1.5 | 560 | | 91.6 | 90.8 | A |
| Ex. 2 | 4N-Al | AlN | ADC12 | 10 | present | ceramics substrate side | 2 | 99.9 | 3.36 | 1.5 | 560 | | 90.2 | 89 | A |
| Ex. 3 | 4N-Al | AlN | ADC12 | 10 | absent | heatsink side | 2 | 99.9 | 3.36 | 1.5 | 560 | | 84.6 | 83.5 | A |
| Ex. 4 | 4N-Al | AlN | ADC12 | 10 | absent | ceramics substrate side | 2 | 99.9 | 3.36 | 1.5 | 560 | | 85.5 | 83.7 | A |
| Ex. 5 | 4N-Al | AlN | ADC12 | 10 | present | heatsink side | 1 | 99.9 | 6.71 | 1.5 | 560 | | 87.6 | 86.3 | A |
| Ex. 6 | 4N-Al | AlN | ADC12 | 10 | present | heatsink side | 10 | 99.9 | 0.67 | 1.5 | 560 | | 89.1 | 88.2 | A |
| Ex. 7 | 4N-Al | AlN | ADC12 | 10 | present | heatsink side | 2 | 89 | 3.68 | 1.5 | 560 | | 88.6 | 85.5 | A |
| Ex. 8 | 4N-Al | AlN | Al-Si | 0.1 | present | heatsink side | 2 | 99.9 | 0.03 | 1.5 | 560 | | 87.6 | 85.5 | A |
| Ex. 9 | Cu | AlN | ADC12 | 10 | present | heatsink side | 2 | 99.9 | 3.36 | 1.5 | 560 | | 90.8 | 90.1 | A |
| Ex. 10 | 4N-Al | Al2O3 | ADC12 | 10 | present | heatsink side | 2 | 99.9 | 3.36 | 1.5 | 560 | | 89.9 | 89.5 | A |
| Ex. 11 | 4N-Al | SiN | ADC12 | 10 | present | heatsink side | 2 | 99.9 | 3.36 | 1.5 | 560 | | 90.5 | 88.6 | A |

| | Configurations of Power Module Substrate with a Heatsink | | | | | | | | | | | Evaluation | | |
| | Metal Plate (Circuit layer) | Ceramics Substrate | Al-SiC Complex Material (Heatsink) | | | Method of Bonding Ceramics Substrate and Heatsink | | | | | | | Initial Bonding Rate (%) | Bonding Rate after Cooling/ Heating Cycles (%) | Matrix Melting |
| | | | Al material | Si concentration (atomic%) | Skin layer | Mg layer | | | | | Load (MPa) | Bonding temperature (°C) | | | |
| | | | | | | Provided location | Thickness (μm) | Purity (atomic%) | Si/Mg | | | | | | |
| Ex. 12 | 4N-Al | AlN | ADC12 | 10 | present | heatsink side | 2 | 99.9 | 3.36 | | 1.5 | 550 | 85.3 | 80.8 | A |
| Ex. 13 | 4N-Al | AlN | ADC12 | 10 | present | heatsink side | 2 | 99.9 | 3.36 | | 1.5 | 575 | 90.9 | 89.8 | A |
| Ex. 14 | 4N-Al | AlN | ADC12 | 10 | present | heatsink side | 0.1 | 99.9 | 67.11 | | 1.5 | 560 | 83.2 | 80.6 | A |
| Ex. 15 | 4N-Al | AlN | Al-Si | 0.04 | present | heatsink side | 2 | 99.9 | 0.01 | | 1.5 | 560 | 86.8 | 82.1 | A |
| Ex. 16 | 4N-Al | AlN | Al-Si | 12.1 | present | heatsink side | 0.1 | 99.9 | 84.60 | | 1.5 | 560 | 84 | 81.4 | A |
| CvEx. 1 | 4N-Al | AlN | ADC12 | 10 | present | Al-10.1mass%Si (thickness: 50μm) | | | | | 0.6 | 610 | 92.1 | 90.1 | B |
| CvEx. 2 | 4N-Al | AlN | ADC12 | 10 | present | Al-10.1mass%Si-15.mass%Mg (thickness: 50μm) | | | | | 0.6 | 610 | 91.5 | 90.2 | B |
| CvEx. 3 | 4N-Al | AlN | ADC12 | 10 | present | Al-10.1mass%Si (thickness: 50μm) | | | | | 0.6 | 560 | 29.2 | 12.7 | A |
| CvEx. 4 | 4N-Al | AlN | ADC12 | 10 | present | Al-10.1mass%Si-15.mass%Mg (thickness: 50μm) | | | | | 0.6 | 560 | 37.6 | 22.2 | A |
| CpEx. 1 | 4N-Al | AlN | ADC12 | 10 | present | heatsink side | 0.05 | 99.9 | 134.23 | | 1.5 | 560 | 64.3 | 59.2 | A |
| CpEx. 2 | 4N-Al | AlN | ADC12 | 10 | present | heatsink side | 15 | 99.9 | 0.13 | | 1.5 | 560 | 69.4 | 64.8 | A |
| CpEx. 3 | 4N-Al | AlN | 4N-Al | 0.01 | absent | heatsink side | 2 | 99.9 | 0.00 | | 1.5 | 560 | 60.3 | 55 | A |
| CpEx. 4 | 4N-Al | AlN | ADC12 | 10 | present | heatsink side | 2 | 99.9 | 3.36 | | 1.5 | 530 | 67.2 | 61 | A |

EP 3 753 912 A1

(continued)

| | Configurations of Power Module Substrate with a Heatsink | | | | | | | | | | | | Evaluation | | |
|---|---|---|---|---|---|---|---|---|---|---|---|---|---|---|---|
| | Metal Plate (Circuit layer) | Ceramics Substrate | Al-SiC Complex Material (Heatsink) | | | Method of Bonding Ceramics Substrate and Heatsink | | | | | | | Initial Bonding Rate (%) | Bonding Rate after Cooling/ Heating Cycles (%) | Matrix Melting |
| | | | Al materi-al | Si concentra-tion (atomic%) | Skin lay-er | Mg layer | | | | Load (MPa) | Bonding temperature (°C) | | | | |
| | | | | | | Provided location | Thickness ($\mu$m) | Purity (atomic%) | Si/Mg | | | | | | |
| CpEx. 5 | 4N-Al | AlN | ADC12 | 10 | present | heatsink side | 2 | 99.9 | 3.36 | 1.5 | 580 | | 92.1 | 90.7 | B |

In Conventional Examples (CvExs.) 1 and 2 in which an Al-Si brazing material foil or an Al-Si-Mg brazing material foil was used and bonded at 610°C, it was confirmed that the matrix melted in the Al-SiC composite material. In Conventional Examples 3 and 4 bonded at 560°C, the bonding rate was low.

In Comparative Example (CmEx.) 1 in which the thickness of the Mg layer was less than 0.1 $\mu$m; Comparative Example 2 in which the thickness of the Mg layer was more than 10 $\mu$m; Comparative Example 3 in which the Si concentration of the aluminum material of the Al-SiC composite material was less than 0.1 atomic%; and Comparative Example 4 in which the bonding temperature was set at a low temperature, the bonding rates were low. In Comparative Example 5 in which the bonding temperature was set at a high temperature, the matrix was melted.

On the other hand, in the power module substrates with a heat sink obtained in Examples (Exs.) of the present invention, it was confirmed that melting of the matrix did not occur, and the bonding rate between the ceramic substrate and the Al-SiC composite material (heat sink) showed a high value.

[Industrial availability]

According to the present invention, it is possible to provide a method of producing a ceramic/Al-SiC composite material bonded body and a method of producing a power module substrate with a heatsink. In there methods, a ceramics member and an Al-SiC composite material are bonded together with high strength without eluting the aluminum material in the Al-SiC composite material by heating them at a relatively low temperature.

[Reference Signs List]

1:     Power module substrate with a heatsink
10:    Power module substrate
11:    Ceramics substrate
12:    Circuit layer
20:    Heatsink
21:    Channel
30:    Al-SiC composite material
31:    Porous body
32:    Aluminum material
33:    Skin layer
40:    Bonding part
41:    Magnesium oxide
51:    Aluminum member
52:    Brazing material
53:    Magnesium layer

**Claims**

1. A method of producing a ceramics/Al-SiC composite material bonded body, a ceramics member and an Al-SiC composite material that includes: a porous body made of SiC; and an aluminum material made of an Al-Si alloy impregnated in the porous body and having a silicon content of 0.1 atomic% or more, being bonded together in the method, the method comprising the steps of:

    forming a magnesium layer having a thickness of 0.1 $\mu$m or more and 10 $\mu$m or less on a surface of at least one of the ceramics member and the Al-SiC composite material;
    obtaining a laminated body by laminating the ceramics member and the Al-SiC composite material via the magnesium layer; and
    bonding the ceramics member and the Al-SiC composite material by heating the laminated body in a temperature range of 550°C or more and 575°C or less.

2. The method of producing a ceramics/Al-SiC composite material bonded body according to claim 1, wherein a ratio Si/Mg in an atomic ratio is in a range of 0.01 or more and 99.0 or less, the ratio Si/Mg being a ratio of a Si amount in the Al-Si alloy existing in a thickness range of 50 $\mu$m from a surface of a bonding surface between the Al-SiC composite material and the ceramics member to a Mg amount existing in the magnesium layer in the laminated body.

3. A method of producing a power module substrate with a heatsink, a ceramics substrate of a power module substrate and a heatsink constituted of a Al-SiC composite material being bonded together in the method, the power module substrate including: a ceramics substrate; and a circuit layer bonded on one surface of the ceramics substrate, and the Al-SiC composite material including: a porous body made of SiC; and an aluminum material made of an Al-Si alloy impregnated in the porous body and having a silicon content of 0.1 atomic% or more, the method comprising the steps of:

forming a magnesium layer having a thickness of 0.1 µm or more and 10 µm or less on a surface of at least one of the ceramics substrate and the Al-SiC composite material;

obtaining a laminated body by laminating the ceramics substrate and the Al-SiC composite material via the magnesium layer; and

bonding the ceramics substrate and the Al-SiC composite material by heating the obtained laminated body in a temperature range of 550°C or more and 575°C or less.

4. The method of producing a power module substrate with a heatsink according to claim 3, wherein a ratio Si/Mg in an atomic ratio is in a range of 0.01 or more and 99.0 or less, the ratio Si/Mg being a ratio of a Si amount in the Al-Si alloy existing in a thickness range of 50 µm from a surface of a bonding surface between the Al-SiC composite material and the ceramics substrate to a Mg amount existing in the magnesium layer in the laminated body.

FIG. 1

FIG. 2A

FIG. 2B

FIG. 3

```
┌─────────────────────────────────────┐
│     CIRCUIT LAYER BONDING STEP       │── S01
└─────────────────────────────────────┘
                  │
                  ▼
   ╭─────────────────────────────────╮
   │      POWER MODULE SUBSTRATE      │
   ╰─────────────────────────────────╯
                  │
  ┌ ─ ─ ─ ─ ─ ─ ─ │ ─ ─ ─ ─ ─ ─ ─ ─ ─ ┐
                  ▼
  │┌───────────────────────────────┐ │
   │   MAGNESIUM LAYER FORMING STEP  │── S21
  │└───────────────────────────────┘ │
                  │
  │               ▼                   │
   ┌───────────────────────────────┐
  ││         LAMINATING STEP        │── S22 │···· S02
   └───────────────────────────────┘
  │               │                   │
                  ▼
  │┌───────────────────────────────┐ │
   │          BONDING STEP          │── S23
  │└───────────────────────────────┘ │
                  │
  └ ─ ─ ─ ─ ─ ─ ─ │ ─ ─ ─ ─ ─ ─ ─ ─ ─ ┘
                  ▼
╭─────────────────────────────────────────╮
│  POWER MODULE SUBSTRATE WITH HEATSINK    │
╰─────────────────────────────────────────╯
```

## FIG. 4

# FIG. 5A

ALUMINUM FLOW OUT

AL-SiC
COMPOSITE
MATERIAL

# FIG. 5B

AL-SiC
COMPOSITE
MATERIAL

CRACK

## INTERNATIONAL SEARCH REPORT

| International application No. |
|---|
| PCT/JP2018/005089 |

**A.  CLASSIFICATION OF SUBJECT MATTER**
Int. Cl. C04B37/00(2006.01)i, H01L23/36(2006.01)i, H01L23/373(2006.01)i

According to International Patent Classification (IPC) or to both national classification and IPC

**B.   FIELDS SEARCHED**

Minimum documentation searched (classification system followed by classification symbols)
Int. Cl. C04B37/00-37/02, H01L23/36, H01L23/373

Documentation searched other than minimum documentation to the extent that such documents are included in the fields searched
Published examined utility model applications of Japan      1922-1996
Published unexamined utility model applications of Japan    1971-2018
Registered utility model specifications of Japan            1996-2018
Published registered utility model applications of Japan    1994-2018

Electronic data base consulted during the international search (name of data base and, where practicable, search terms used)

**C.   DOCUMENTS CONSIDERED TO BE RELEVANT**

| Category* | Citation of document, with indication, where appropriate, of the relevant passages | Relevant to claim No. |
|---|---|---|
| X | JP 2017-183360 A (MITSUBISHI MATERIALS CORP.) 05 October 2017, claims, paragraph [0021] (Family: none) | 1-4 |
| Y | JP 2010-98058 A (MITSUBISHI MATERIALS CORP.) 30 April 2010, claims, paragraphs [0019], [0043]-[0046], [0049] (Family: none) | 1-4 |
| Y | JP 2017-183716 A (MITSUBISHI MATERIALS CORP.) 05 October 2017, claims, paragraph [0023] (Family: none) | 1-4 |
| Y | JP 2012-116683 A (SHOWA DENKO KABUSHIKI KAISHA) 21 June 2012, claims, paragraphs [0002], [0042] (Family: none) | 1-4 |

☒  Further documents are listed in the continuation of Box C.    ☐   See patent family annex.

| | |
|---|---|
| *      Special categories of cited documents: | "T"   later document published after the international filing date or priority date and not in conflict with the application but cited to understand the principle or theory underlying the invention |
| "A"   document defining the general state of the art which is not considered to be of particular relevance | |
| "E"   earlier application or patent but published on or after the international filing date | "X"   document of particular relevance; the claimed invention cannot be considered novel or cannot be considered to involve an inventive step when the document is taken alone |
| "L"   document which may throw doubts on priority claim(s) or which is cited to establish the publication date of another citation or other special reason (as specified) | "Y"   document of particular relevance; the claimed invention cannot be considered to involve an inventive step when the document is combined with one or more other such documents, such combination being obvious to a person skilled in the art |
| "O"   document referring to an oral disclosure, use, exhibition or other means | |
| "P"   document published prior to the international filing date but later than the priority date claimed | "&"   document member of the same patent family |

| Date of the actual completion of the international search | Date of mailing of the international search report |
|---|---|
| 28.03.2018 | 10.04.2018 |

| Name and mailing address of the ISA/ | Authorized officer |
|---|---|
| Japan Patent Office<br>3-4-3, Kasumigaseki, Chiyoda-ku,<br>Tokyo 100-8915, Japan | |
| | Telephone No. |

Form PCT/ISA/210 (second sheet) (January 2015)

**INTERNATIONAL SEARCH REPORT**

International application No.

PCT/JP2018/005089

C (Continuation).   DOCUMENTS CONSIDERED TO BE RELEVANT

| Category* | Citation of document, with indication, where appropriate, of the relevant passages | Relevant to claim No. |
|---|---|---|
| E, X | JP 2018-32732 A (MITSUBISHI MATERIALS CORP.) 01 March 2018, claims (Family: none) | 1-4 |
| A | JP 59-164675 A (NISSAN MOTOR CO., LTD.) 17 September 1984, claims, page 5, upper left column, lines 5-9 (Family: none) | 1-4 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010098058 A